# EUROPEAN PATENT APPLICATION

(11) **EP 4 845 378 A1**
(43) Date of publication of application: **25.11.2026**
(21) Application number: 26179904.3
(22) Date of filing: 20.05.2026
(51) Int. Cl.: H10W 44/00, H10D 1/68, H10W 70/60, H10W 90/10, H10W 90/00

(54) **SEMICONDUCTOR PACKAGE**

(30) Priority: 21.05.2025 KR 20250066006
(71) Applicant: ELSPES Inc., Daejeon (KR)
(72) Inventor: LIM, Seunggu, Hwaseong-si, Gyeonggi-do (KR); Murti, Wisnu, Hwaseong-si, Gyeonggi-do (KR); KIM, Ui Hwan, Hwaseong-si, Gyeonggi-do (KR); PARK, Yeong Lyeol, Yongin-si, Gyeonggi-do (KR)
(74) Representative: Jung, Minkyu

(57) **Abstract**

The present disclosure relates to a semiconductor package. The semiconductor package of the present disclosure includes a package substrate, a first semiconductor die disposed on the package substrate, a second semiconductor die disposed to be spaced apart from the first semiconductor die on the package substrate, and a capacitor chip disposed on at least one electrical path between the first semiconductor die and the second semiconductor die on the package substrate, wherein the capacitor chip includes a substrate including a plurality of trenches, at least one first trench capacitor disposed in one area of the substrate, and at least one second trench capacitor disposed to be spaced apart from the at least one first trench capacitor in another area of the substrate, the at least one first trench capacitor couples the first semiconductor die and the second semiconductor die, the at least one second trench capacitor is a decoupling capacitor connected to the first semiconductor die or the second semiconductor die. Common mode noise can be blocked in chip-to-chip communication, and electromagnetic interference (EMI) performance can be improved. Accordingly, the present disclosure enables improved power integrity and high-speed signal transmission by combining vertical TSV/TGV power paths with horizontal AC coupling paths, thereby improving signal integrity.

## Description

### CROSS-REFERENCE TO RELATED APPLICATION

This application claims priority to and the benefit of Korean Patent Application No. 2025-0066006, filed on May 21, 2025, the disclosure of which is incorporated herein by reference in its entirety.

### BACKGROUND

### 1. Field of the Invention

The present disclosure relates to a semiconductor package, and more particularly, to a semiconductor package including a capacitor chip in which a coupling capacitor and a decoupling capacitor are integrated.

### 2. Discussion of Related Art

With the rapid development of portable electronic devices such as smartphones, tablets, and wearable devices, the demand for technology that simultaneously satisfies high performance and low power consumption while being miniaturized is increasing. In response to this demand, semiconductor devices are being developed to meet the trend of miniaturization and high integration of electronic devices, but the existing multi-chip design method has encountered problems such as increased connection complexity between components, increased data transmission delay, and increased power consumption.

To solve these problems, a system on chip (SoC) structure in which a central processing unit (CPU), a graphics processing unit (GPU), a digital signal processor (DSP), a neural network processing unit (NPU), radio frequency (RF) circuits, communication modems (Long Term Evolution (LTE)/fifth-generation (5G)), and memory blocks are integrated into a single chip has been proposed. SoCs have the advantage of reducing circuit complexity by simplifying inter-chip interfaces and improving operating speed and power efficiency. However, there is a technical constraint in the SoC design method that heterogeneous components should be integrated in a single process. For example, some components require a 3 nm or 4 nm advanced process, but some components can be sufficiently implemented with a 28 nm or 40 nm process. In this case, when components are integrated in a 3 nm or 4 nm advanced process, problems of excessive manufacturing costs and resource consumption may arise for chips that can be implemented with a 28 nm or 40 nm process. In addition, when heterogeneous components are designed based on different materials, processes suitable for the characteristics of the materials are required, and thus when this is implemented as a single process, process optimization can be difficult and overall manufacturing efficiency and a yield can be degraded.

Therefore, a technology for solving the above-described problems has become necessary.

Meanwhile, the foregoing background art is technical information that the inventors have possessed for derivation of the present disclosure or acquired during the derivation process, and thus the technical information cannot necessarily be referred to as the known art disclosed to the general public prior to the filing of the present disclosure.

### [Related Art Document]

### [Patent Document]

(Patent Document 1) U.S. Laid-Open Patent Publication No. 2013/0134607 (May 30, 2013)

### SUMMARY OF THE INVENTION

The present invention is directed to providing a semiconductor package capable of high-speed signal transmission while reducing the complexity of connections between a plurality of semiconductor dies.

The present invention is also directed to providing a semiconductor package that allows heterogeneous semiconductor dies are integrated, which are implemented using different processes or materials, into a single package.

The present invention is also directed to providing a semiconductor package in which semiconductor dies formed through optimized processes are mounted so as to prevent problems of reducing manufacturing production efficiency and power efficiency.

The problems to be solved by the present disclosure are not limited to the above-described problems, and other problems that are not mentioned can be clearly understood by those skilled in the art from the following description.

According to an aspect of the present disclosure, there is provided a semiconductor package including a package substrate, a first semiconductor die disposed on the package substrate, a second semiconductor die disposed to be spaced apart from the first semiconductor die on the package substrate, and a capacitor chip disposed on at least one electrical path between the first semiconductor die and the second semiconductor die on the package substrate, wherein the capacitor chip includes a substrate including a plurality of trenches, at least one first trench capacitor disposed in one area of the substrate, and at least one second trench capacitor disposed to be spaced apart from the at least one first trench capacitor in another area of the substrate, the at least one first trench capacitor couples the first semiconductor die and the second semiconductor die, and the at least one second trench capacitor is a decoupling capacitor connected to the first semiconductor die or the second semiconductor die.

According to another aspect of the present disclosure, the first semiconductor die and the second semiconductor die may be heterogeneous semiconductor dies having different driving voltages.

According to still another aspect of the present disclosure, when the at least one second trench capacitor is provided as a plurality of second trench capacitors, the first semiconductor die and the second semiconductor die may be connected to different second trench capacitors.

According to yet another aspect of the present disclosure, the capacitor chip may be disposed in the package substrate.

According to yet another aspect of the present disclosure, the capacitor chip may be disposed below the first semiconductor die or the second semiconductor die and be directly connected to a lower surface of the first semiconductor die or the second semiconductor die.

According to yet another aspect of the present disclosure, the semiconductor package may further include an interposer disposed between the first and second semiconductor dies and the package substrate, and the capacitor chip may be disposed in the interposer.

According to yet another aspect of the present disclosure, the at least one first trench capacitor may include a plurality of first trench capacitors, and the plurality of first trench capacitors may be connected in parallel.

According to yet another aspect of the present disclosure, the semiconductor package may further include a plurality of switches disposed between each of the plurality of first trench capacitors and the first semiconductor die or disposed between each of the plurality of first trench capacitors and the second semiconductor die, and the plurality of first trench capacitors may have different capacitances.

According to yet another aspect of the present disclosure, the at least one first trench capacitor may include a plurality of first trench capacitors, and when at least one electrical path is provided as a plurality of electrical paths, the plurality electrical paths may be connected to the capacitor chip, each of the plurality of electrical paths may connect the first semiconductor die and the second semiconductor die through each of the plurality of first trench capacitors.

According to yet another aspect of the present disclosure, the plurality of first trench capacitors may have different capacitances.

According to yet another aspect of the present disclosure, the plurality of electrical paths may include electrical paths formed of conductive lines, and the conductive lines may DC-couple the first semiconductor die and the second semiconductor die.

According to yet another aspect of the present disclosure, the capacitor chip is embedded in the interposer, and the trench capacitors in the capacitor chip are electrically connected to the semiconductor dies through internal routing layers of the interposer.

According to yet another aspect of the present disclosure, the interposer may include at least one through-interposer via (TIV), and the second trench capacitor may be electrically connected to one of the semiconductor dies through the at least one TIV.

According to yet another aspect of the present disclosure, the capacitor chip may further include a through-silicon via (TSV), and the TSV may electrically connect the package substrate and the first semiconductor die or the second semiconductor die through the at least one TIV.

### BRIEF DESCRIPTION OF THE DRAWINGS

The above and other objects, features and advantages of the present invention will become more apparent to those of ordinary skill in the art by describing exemplary embodiments thereof in detail with reference to the accompanying drawings, in which:
FIG. 1 is a top view illustrating a semiconductor package according to one embodiment of the present disclosure;
FIG. 2 is a schematic top view illustrating a capacitor chip of FIG. 1;
FIG. 3 is a cross-sectional view illustrating the semiconductor package of FIG. 1 in a III-III' direction;
FIG. 4 is a cross-sectional view illustrating the semiconductor package of FIG. 1 in the III-III' direction according to another embodiment;
FIG. 5 is a cross-sectional view illustrating the semiconductor package of FIG. 1 in the III-III' direction according to still another embodiment;
FIG. 6 is a top view illustrating a semiconductor package according to another embodiment of the present disclosure;
FIG. 7 is a top view illustrating a semiconductor package according to still another embodiment of the present disclosure;
FIG. 8 is a schematic top view illustrating a capacitor chip according to another embodiment of the present disclosure; and
FIG. 9 is a schematic top view illustrating a capacitor chip according to still another embodiment of the present disclosure.

### DETAILED DESCRIPTION OF EXEMPLARY EMBODIMENTS

Advantages and features of the present disclosure and methods for achieving them will be made clear from embodiments described in detail below with reference to the accompanying drawings. The present disclosure may, however, be implemented in many different forms and should not be construed as being limited to the embodiments set forth herein, and the embodiments are provided such that this disclosure will be thorough and complete and will fully convey the scope of the present disclosure to those skilled in the art to which the present disclosure pertains, and the present disclosure is defined by only the scope of the appended claims.

Shapes, sizes, ratios, angles, numbers, and the like disclosed in the drawings for describing the embodiments of the present disclosure are illustrative, and thus the present disclosure is not limited to the illustrated matters. Further, in the following description of the present disclosure, when a detailed description of a known related art is determined to unnecessarily obscure the gist of the present disclosure, the detailed description thereof will be omitted herein. When the terms "including," "having," "consisting of," and the like mentioned in the present disclosure are used, other parts may be added unless the term "only" is used herein. When a component is expressed in a singular number, the plural number is included unless otherwise specified.

In analyzing a component, it is interpreted as including an error range even when there is no explicit description.

Although the terms "first," "second," and the like are used to describe various components, these components are not substantially limited by these terms. These terms are used only to distinguish one component from another component. Therefore, a first component described below may be substantially a second component within the technical spirit of the present disclosure.

Unless otherwise specified, the same reference numerals refer to the same components throughout the present specification.

The individual features of the various embodiments of the present disclosure may be partially or entirely combined or mixed with each other, and various technical connections and operations are possible, as can be fully understood by those skilled in the art, and the individual embodiments may be implemented independently of each other or may be implemented together in an associated relationship.

Hereinafter, the present disclosure will be described in detail with reference to the accompanying drawings.

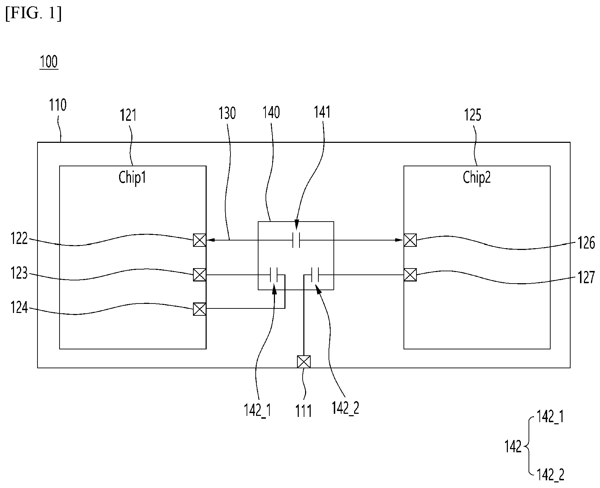

FIG. 1 is a top view illustrating a semiconductor package according to one embodiment of the present disclosure.

Referring to FIG. 1, a semiconductor package 100 includes a package substrate 110, a first semiconductor die 121, a second semiconductor die 125, and a capacitor chip 140.

The semiconductor package 100 may be a device that protects semiconductor dies 121 and 125 and connects the semiconductor dies 121 and 125 to an external circuit. Specifically, the semiconductor package 100 may be a device in which heterogeneous semiconductor dies 121 and 125 are integrated into one package and which electrically connects the semiconductor dies 121 and 125 to each other or to an external circuit. For example, the semiconductor package 100 may be a system in package (SiP).

Referring to FIG. 1, the package substrate 110 is a substrate for a semiconductor package. The package substrate 110 may connect at least one of the semiconductor dies 121 and 125 disposed on the package substrate 110 to external devices, other semiconductor dies, or components. Specifically, the package substrate 110 may connect heterogeneous components disposed on the package substrate 110 to each other through bridge lines or to an external device through rearrangement lines.

The package substrate 110 may include a printed circuit board (PCB), an organic substrate, a ceramic substrate, a glass substrate, a silicon substrate, and a tape line substrate. For example, the package substrate 110 may be any one of a one-sided printed circuit substrate (one-sided PCB), a double-sided printed circuit substrate (double-sided PCB), and a multi-layer printed circuit substrate (multi-layer PCB).

Referring to FIG. 1, the first semiconductor die 121 and the second semiconductor die 125 may be various electronic components, chips, or modules. For example, the first semiconductor die 121 and the second semiconductor die 125 may include at least one of a central processing unit (CPU), a graphics processing unit (GPU), a neural network processing unit (NPU), a memory, a communication module, and a radio frequency (RF) module. In some cases, the first semiconductor die 121 and the second semiconductor die 125 may be different electronic components. Specifically, the first semiconductor die 121 and the second semiconductor die 125 may be heterogeneous semiconductor dies manufactured through different manufacturing processes. Preferably, the first semiconductor die 121 and the second semiconductor die 125 may be chips, dies, or modules of different sizes produced by a fine process. For example, the first semiconductor die 121 may be a processor, and the second semiconductor die 125 may be a memory device. Specifically, the first semiconductor die 121 may be a processor manufactured using a 3 nm to 4 nm advanced process, and the second semiconductor die 125 may be a memory device manufactured using a 40 nm process.

The first semiconductor die 121 and the second semiconductor die 125 may include chip-to-chip communication parts 122 and 126, power voltage parts 123 and 127, or a reference voltage part 124. For example, the first semiconductor die 121 may include the chip-to-chip communication part 122, the power voltage part 123, or the reference voltage part 124, and the second semiconductor die 125 may include the chip-to-chip communication part 126, the power voltage part 127, or a reference voltage part (not shown).

The chip-to-chip communication parts 122 and 126 may be circuits or structures that apply or receive chip-to-chip communication signals. For example, the chip-to-chip communication parts 122 and 126 may be circuit blocks that generate or process chip-to-chip communication signals, driver circuits that transmit the chip-to-chip communication signals, receiver circuits that receive the chip-to-chip communication signals, chip-to-chip communication lines, communication pads connected to the chip-to-chip communication lines, or bumps connected to the chip-to-chip communication lines.

The power voltage parts 123 and 127 may be areas to which a power voltage VDD of the semiconductor dies 121 and 125 is applied. For example, the power voltage parts 123 and 127 may be internal power voltage lines through which the power voltage is distributed, power pads to which the power voltage is externally applied or connected, bumps connected to the power voltage lines or power pads, or circuit blocks that supply, regulate, or distribute the power voltage.

The reference voltage part (not shown) may be an area to which a reference voltage VSS of the semiconductor dies 121 and 125 is applied. For example, the reference voltage part may be an internal reference voltage line, a reference voltage pad, a bump connected to the reference voltage line or the reference voltage pad, or a portion of a ground node that receives a reference voltage from the outside or forms a reference point of an internal circuit.

The first semiconductor die 121 and the second semiconductor die 125 may have different driving voltages. Specifically, the first semiconductor die 121 and the second semiconductor die 125 may have power voltages of different levels or reference voltages of different levels. That is, the first semiconductor die 121 and the second semiconductor die 125 may be driven by voltages of different levels. For example, a power voltage VDD applied to the power voltage part 123 of the first semiconductor die 121 may be different from a power voltage VDD' applied to the power voltage part 127 of the second semiconductor die 125. In addition, a reference voltage VSS applied to the reference voltage part 124 of the first semiconductor die 121 may be different from a reference voltage VSS' applied to the reference voltage part (not shown) of the second semiconductor die 125. In some cases, the reference voltage part 124 of the first semiconductor die 121 and the reference voltage part of the second semiconductor die 125 may have the same reference voltage. For example, the reference voltage part 124 of the first semiconductor die 121, the reference voltage part 124 of the second semiconductor die 125, or the reference voltage part 111 of the package substrate 110 may have a ground voltage. According to various embodiments of the present invention, the first semiconductor die 121 and the second semiconductor die 125 may have the same driving voltage. That is, the first semiconductor die 121 and the second semiconductor die 125 may be homogeneous semiconductor dies having the same driving voltage.

The first semiconductor die 121 and the second semiconductor die 125 may be disposed on the package substrate 110. Specifically, the first semiconductor die 121 and the second semiconductor die 125 may be disposed to be spaced apart from each other on the package substrate 110. In some cases, the first semiconductor die 121 and the second semiconductor die 125 may be disposed adjacent to each other. Alternatively, the first semiconductor die 121 and the second semiconductor die 125 may be disposed in contact with each other. Thus, the semiconductor package 100 is miniaturized and has improved integration and may integrate functions between the semiconductor dies 121 and 125 more efficiently.

The first semiconductor die 121 and the second semiconductor die 125 may be electrically connected. Specifically, at least one electrical path 130 may be formed between the first semiconductor die 121 and the second semiconductor die 125. The first semiconductor die 121 and the second semiconductor die 125 may perform chip-to-chip communication through at least one electrical path 130.

Referring to FIG. 1, the capacitor chip 140 may be a chip including at least one first capacitor 141 and at least one second capacitor 142. In addition, the capacitor chip 140 may be a passive component integrated chip formed through a separate manufacturing process from the first semiconductor die 121, the second semiconductor die 125, or the package substrate 110. That is, the capacitor chip 140 may be a passive component integrated chip in which the first capacitor 141 and the second capacitor 142 are formed on a single substrate independent from the package substrate 110. In some cases, the capacitor chip 140 may be a passive component integrated chip formed integrally on the package substrate 110.

The capacitor chip 140 may be disposed between the first semiconductor die 121 and the second semiconductor die 125. Specifically, the capacitor chip 140 may be disposed on at least one electrical path 130 between the first semiconductor die 121 and the second semiconductor die 125. That is, the capacitor chip 140 may be disposed to be coupled to the chip-to-chip communication line between the first semiconductor die 121 and the second semiconductor die 125.

Referring to FIG. 1, the capacitors 141 and 142 may be various types of capacitors. For example, the capacitors 141 and 142 may be any one of a trench capacitor, a silicon capacitor, an embedded capacitor, and a thin film capacitor. Preferably, the capacitors 141 and 142 may be deep trench capacitors (DTCs). Thus, the semiconductor package 100 includes a deep trench capacitor capable of securing a capacity in a vertical direction and being advantageous for miniaturization, and thus the semiconductor package 100 can efficiently provide capacitance to semiconductor dies in a limited space.

The first capacitor 141 may be disposed on at least one electrical path 130 between the first semiconductor die 121 and the second semiconductor die 125. Specifically, the first capacitor 141 may be disposed such that one electrode of the first capacitor 141 is connected to the first semiconductor die 121 through the electrical path 130, and the other electrode thereof is connected to the second semiconductor die 125 through the electrical path 130. For example, the first capacitor 141 may be disposed such that one electrode of the first capacitor 141 is connected to the chip-to-chip communication part 122 of the first semiconductor die 121, and the other electrode thereof is connected to the chip-to-chip communication part 126 of the second semiconductor die 125. That is, the first capacitor 141 may be a coupling capacitor disposed on the chip-to-chip communication line between the first semiconductor die 121 and the second semiconductor die 125. More specifically, the first capacitor 141 may be an AC coupling capacitor for transmitting an AC signal between the first semiconductor die 121 and the second semiconductor die 125. Accordingly, the first capacitor 141 removes a DC component in the chip-to-chip communication between the first semiconductor die 121 and the second semiconductor die 125 and passes only the high-frequency signal, and thus the first capacitor 141 can remove a DC offset between the first semiconductor die 121 and the second semiconductor die 125 and block common mode noise. Therefore, the first capacitor 141 may improve electromagnetic interference (EMI) performance and enhance signal integrity in the chip-to-chip communication between the first semiconductor die 121 and the second semiconductor die 125. In addition, the first capacitor 141 may improve compatibility between heterogeneous semiconductor dies by removing a DC offset in the chip-to-chip communication.

At least one second capacitor 142 may be electrically connected to the first semiconductor die 121 or the second semiconductor die 125. Specifically, the second capacitor 142 may be disposed such that one electrode of the second capacitor 142 is connected to one of the semiconductor dies 121 and 125 or one of the power voltage part and the reference voltage part of the package substrate 110, and the other electrode thereof is connected to the other of the semiconductor dies 121 and 125 or the other of the power voltage part and the reference voltage part of the package substrate 110. In this case, the semiconductor dies 121 and 125 may be electrically connected to the power voltage part and the reference voltage part of the package substrate 110, respectively. For example, as shown in FIG. 1, a first second capacitor 142_1 may be disposed such that one electrode of the first second capacitor 142_1 is connected to the power voltage part 123 of the first semiconductor die 121 and the other electrode thereof is connected to the reference voltage part 124 of the first semiconductor die 121. In addition, a second second capacitor 142_2 may be disposed such that one electrode of the second second capacitor 142_2 is connected to the power voltage part 127 of the second semiconductor die 125 and the other electrode thereof is connected to the reference voltage part 111 of the package substrate 110. In this case, the reference voltage part 111 of the package substrate 110 and the reference voltage part (not shown) of the second semiconductor die 125 may be electrically connected. That is, the second capacitor 142 may be a decoupling capacitor connected to the driving voltage of the first semiconductor die 121 or the second semiconductor die 125. Thus, the second capacitor 142 may operate as a decoupling capacitor that suppresses noise from the power supply of the first semiconductor die 121 or the second semiconductor die 125 and provides power stability.

The semiconductor package 100 according to one embodiment of the present disclosure includes the heterogeneous first semiconductor die 121 and the second semiconductor die 125, and thus each of the semiconductor dies 121 and 125 can be efficiently disposed for a specialized task. In addition, chips or modules manufactured through different processes or manufactured in different sizes are disposed in one package substrate 110, and thus integration, manufacturing process efficiency, and a yield of the chips disposed within the package substrate 110 can be improved.

The semiconductor package 100 according to one embodiment of the present disclosure includes the capacitor chip 140 coupling the first semiconductor die 121 and the second semiconductor die 125, and thus the semiconductor package 100 may remove a DC component in the chip-to-chip communication between the first semiconductor die 121 and the second semiconductor die 125 and pass only a high-frequency signal. Thus, the semiconductor package 100 may reduce signal loss and power interference due to a voltage level difference between chiplets and enable reliable signal transmission and stable power supply. In addition, the semiconductor package 100 may improve EMI performance and enhance signal integrity by blocking common mode noise in the chip-to-chip communication. In addition, the semiconductor package 100 may remove a DC offset between heterogeneous semiconductor dies and improve compatibility.

In addition, the semiconductor package 100 according to one embodiment of the present disclosure may suppress power noise and maintain power stability due to having the capacitor chip 140 having a decoupling capacitor of the semiconductor dies 121 and 125. Thus, the semiconductor package 100 may improve power integrity by preventing a malfunction or timing error due to power noise. In particular, the semiconductor package 100 includes the capacitor chip 140 having a decoupling capacitor connected to each of the heterogeneous semiconductor dies, and thus the semiconductor package 100 can prevent interference between different power domains and secure power integrity of each power domain.

In addition, the semiconductor package 100 according to one embodiment of the present disclosure includes the capacitor chip 140 in which a coupling capacitor and a decoupling capacitor are disposed, and thus an arrangement area occupied by a plurality of capacitors can be reduced within the semiconductor package 100. Thus, in the semiconductor package 100, a layout area of a plurality of capacitors is reduced so that a line length connected to the capacitors may be shortened and design flexibility may be improved.

In addition, in the semiconductor package 100 according to one embodiment of the present disclosure, since a plurality of capacitors are integrated into one capacitor chip 140, the number of components mounted in the package and the packaging process can be simplified. Thus, a manufacturing process time and manufacturing cost of the semiconductor package 100 can be reduced.

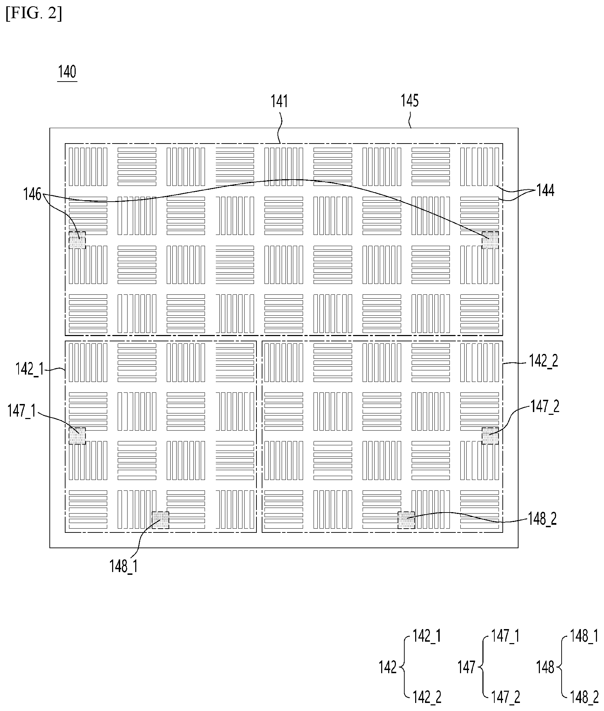

FIG. 2 is a schematic top view illustrating a capacitor chip of FIG. 1.

Referring to FIG. 2, the capacitor chip 140 according to the present embodiment may further include a substrate 145, a first connecting member 146, a second connecting member 147, or a third connecting member 148.

Referring to FIG. 2, the substrate 145 may include various materials. Specifically, the substrate 145 may include a semiconductor material. For example, the substrate 145 may include semiconductor elements such as silicon and germanium or compound semiconductors such as SiC, GaAs, InAs, and InP. Preferably, the substrate 145 may be a silicon substrate.

The substrate 145 may be a separate substrate from the package substrate 110 or an interposer (not shown). The substrate 145 is a substrate independent of the package substrate 110 or the interposer and may be mounted on, attached to, or embedded in the package substrate 110 or the interposer. According to various embodiments of the present disclosure, the substrate 145 may be the same substrate as the package substrate 110 or the interposer. That is, the substrate 145 may be formed integrally with the package substrate 110 or the interposer.

A plurality of trenches 144 may be formed at one side of the substrate 145. The plurality of trenches 144 may be disposed in various forms in the substrate 145. Specifically, the plurality of trenches 144 may include, in the substrate 145 when viewed from above, a plurality of trenches 144 extending horizontally and a plurality of trenches 144 extending vertically. For example, the plurality of trenches 144 may have a form in which a horizontal trench unit formed of a plurality of trenches 144 extending horizontally and a vertical trench unit formed of a plurality of trenches 144 extending vertically are alternately disposed in the substrate 145 when viewed from above.

The plurality of trenches 144 formed in the substrate 145 may be disposed regularly. Specifically, the plurality of trenches 144 may be disposed at a uniform density. For example, when the most adjacently disposed horizontal trench unit and vertical trench unit are set as one trench unit, a density of the trench units in one area of the substrate 145 and a density of the trench units in another area of the substrate 145 may be the same.

Referring to FIG. 2, the capacitors 141 and 142 may be disposed in the plurality of trenches 144. Specifically, the capacitors 141 and 142 may be disposed on an upper surface of the substrate 145 and in the plurality of trenches 144. That is, the area where the plurality of trenches 144 are disposed may be the area where the capacitors 141 and 142 are disposed.

The capacitors 141 and 142 may have various capacitances. Specifically, the first capacitor 141 may have various capacitances according to a communication frequency of the chip-to-chip communication line, and the second capacitor 142 may have various capacitances according to a driving voltage of the semiconductor dies 121 and 125. That is, the plurality of second capacitors 142 may have different capacitances. For example, when the semiconductor dies 121 and 125 are heterogeneous chips with different driving voltages, a capacitance of the first second capacitor 142_1 and a capacitance of the second second capacitor 142_2 may be different. Specifically, the capacitance of the second second capacitor 142_2 may be greater than the capacitance of the first second capacitor 142_1.

A size of the area where the capacitors 141 and 142 are disposed may be proportional to a size of the capacitance of each of the capacitors 141 and 142 in a plane direction of the substrate 145. Specifically, when the plurality of trenches 144 are formed at a uniform density in the substrate 145, the size of the area where the capacitors 141 and 142 are disposed may be proportional to sizes of the capacitances of the capacitors 141 and 142. For example, as shown in FIG. 2, when the capacitance of the second second capacitor 142_2 is greater than the capacitance of the first second capacitor 142_1, an area where the second second capacitor 142_2 is disposed may be greater than the area where the first second capacitor 142_1 is disposed. In some cases, the capacitance of the first second capacitor 142_1 may be greater than the capacitance of the second second capacitor 142_2, and the capacitance of the second second capacitor 142_2 may be greater than the capacitance of the first capacitor 141.

Referring to FIG. 2, the capacitors 141 and 142 may include at least one of connecting members 146, 147, and 148. Specifically, the first capacitor 141 may include a plurality of first connecting members 146 connected to the semiconductor dies 121 and 125, and the second capacitor 142 may include a second connecting member 147 connected to the power voltages VDD and VDD' and a third connecting member 148 connected to the reference voltages VSS and VSS'. For example, the first capacitor 141 may include first connecting members 146 connected to the first semiconductor die 121 and first connecting members 146 connected to the second semiconductor die 125. The first second capacitor 142_1 may include a second connecting member 147_1 connected to the power voltage VDD of the first semiconductor die 121 and a third connecting member 148_1 connected to the reference voltage VSS of the first semiconductor die 121. The second second capacitor 142_2 may include a second connecting member 147_2 connected to the power voltage VDD' of the second semiconductor die 125 and a third connecting member 148_2 connected to the reference voltage VSS' of the second semiconductor die 125.

The connecting members 146, 147, and 148 may include various types of pads or bumps. For example, the connecting members 146, 147, and 148 may each include Cu pads, W pads, Ni/Au pads, Al pads, solder balls, flip chip bumps, Cu bumps, Au bumps, or polymer bumps. In some cases, the connecting members 146, 147, and 148 may each have a structure in which pads and bumps are stacked.

The connecting members 146, 147, and 148 may be disposed outside the capacitor chip 140. Specifically, the connecting members 146, 147, and 148 may be disposed on an upper or lower side of the capacitor chip 140. For example, all the connecting members 146, 147, and 148 may be disposed on an upper surface of the capacitor chip 140. In some cases, the first connecting members 146 and the second connecting member 147 may be disposed on the upper surface of the capacitor chip 140, and the third connecting member 148 may be disposed on a lower surface of the capacitor chip 140.

The connecting members 146, 147, and 148 may be disposed to overlap the capacitors 141 and 142. Specifically, the connecting members 146, 147, and 148 may be disposed to overlap each of the electrically connected capacitors 141 and 142 in a direction perpendicular to a flat surface of the substrate 145. For example, the first connecting members 146 may be disposed to overlap the first capacitor 141 in a direction perpendicular to the flat surface of the substrate 145, and the second connecting member 147 and the third connecting member 148 may be disposed to overlap the second capacitor 142 in a direction perpendicular to the flat surface of the substrate 145.

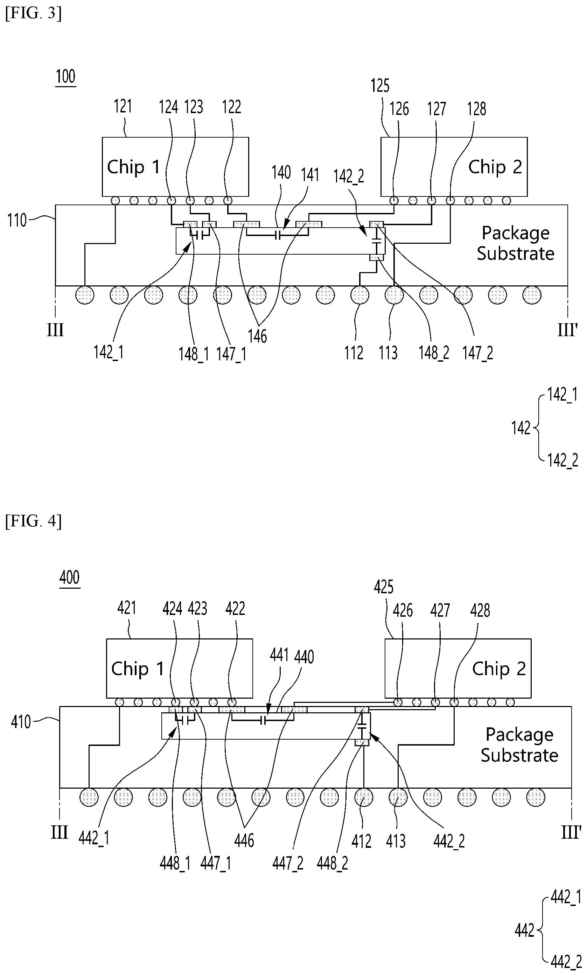

FIG. 3 is a cross-sectional view illustrating the semiconductor package of FIG. 1 in a III-III' direction.

Referring to FIG. 3, the semiconductor package 100 may further include fourth connecting members 112 and fifth connecting members 113.

Referring to FIG. 3, the fourth connecting members 112 and the fifth connecting members 113 may be disposed on a lower portion of the package substrate 110. For example, the fourth connecting members 112 and the fifth connecting members 113 may be pads or bumps disposed on a lower surface of the package substrate 110.

The fourth connecting members 112 and the fifth connecting members 113 may include various types of pads or bumps. For example, the fourth connecting members 112 and the fifth connecting members 113 may include Cu pads, W pads, Ni/Au pads, Al pads, solder balls, flip chip bumps, Cu bumps, Au bumps, or polymer bumps. In some cases, the fourth connecting members 112 and the fifth connecting members 113 may each have a structure in which pads and bumps are stacked.

The fourth connecting members 112 and the fifth connecting members 113 may connect the package substrate 110 to an external device. For example, the fourth connecting members 112 and the fifth connecting members 113 may connect the package substrate 110 to a PCB disposed below the package substrate 110. In some cases, the fourth connecting members 112 and the fifth connecting members 113 may receive a power voltage or a reference voltage from an external device. That is, the fourth connecting members 112 and the fifth connecting members 113 may each be the power voltage part, the reference voltage part 111, or the ground part of the package substrate 110.

The fourth connecting members 112 and the fifth connecting members 113 may be electrically connected to the semiconductor dies 121 and 125 or the capacitor chip 140. For example, the fourth connecting members 112 may be electrically connected to the second capacitor 142 of the capacitor chip 140, and the fifth connecting members 113 may be electrically connected to the semiconductor dies 121 and 125. In some cases, the fourth connecting members 112 and the fifth connecting members 113 may be electrically connected. When the fourth connecting members 112 and the fifth connecting members 113 are electrically connected, the second capacitor 142 of the capacitor chip 140 may be electrically connected to the semiconductor dies 121 and 125 through the fourth connecting members 112 and the fifth connecting members 113.

Referring to FIG. 3, the chip-to-chip communication parts 122 and 126, the power voltage parts 123 and 127, and the reference voltage parts 124 and 128 may be disposed on lower portions of the semiconductor dies 121 and 125. Specifically, the chip-to-chip communication parts 122 and 126, the power voltage parts 123 and 127, and the reference voltage parts 124 and 128 may be disposed between lower surfaces of the semiconductor dies 121 and 125 and an upper surface of the package substrate 110.

Referring to FIG. 3, the capacitor chip 140 may be disposed at the package substrate 110. Specifically, the capacitor chip 140 may be disposed in the package substrate 110. That is, the capacitor chip 140 may be embedded in the package substrate 110.

Referring to FIG. 3, the capacitor chip 140 may be connected to the first semiconductor die 121 and the second semiconductor die 125 through lines of the package substrate 110. For example, the first capacitor 141 may include a first connecting member 146 connected to the chip-to-chip communication part 122 of the first semiconductor die 121 through a bridge line, and a first connecting member 146 connected to the chip-to-chip communication part 126 of the second semiconductor die 125 through a bridge line. The bridge line may be the electrical path 130 of FIG. 1. In addition, the second capacitor 142 may include the second connecting member 147 connected to the power voltage parts 123 and 127 of the semiconductor dies 121 and 125 through the lines of the package substrate 110, and the third connecting member 148 connected to the reference voltage parts 124 and 128 of the semiconductor dies 121 and 125 through the lines of the package substrate 110. In some cases, the second capacitor 142 may include the second connecting member 147 connected to the power voltage parts 123 and 127 of the semiconductor dies 121 and 125 or the fourth connecting members 112 of the package substrate 110 through the lines of the package substrate 110, and the third connecting member 148 connected to the reference voltage parts 124 and 128 of the semiconductor dies 121 and 125 or to the fourth connecting members 112 of the package substrate 110 through the lines of the package substrate 110. For example, the third connecting member 148_2 of the second second capacitor 142_2 may be connected to the fourth connecting members 112 of the package substrate 110 and may be electrically connected to the reference voltage part 128 of the second semiconductor die 125 through the fifth connecting members 113 that are electrically connected to the fourth connecting members 112.

The semiconductor package 100 according to one embodiment of the present disclosure includes the capacitor chip 140 in which a coupling capacitor and a decoupling capacitor are integrated into one substrate, and thus the number of components in the package may be reduced and internal space of the package may be saved. Accordingly, the semiconductor package 100 may implement a highly integrated and high-performance system.

FIG. 4 is a cross-sectional view illustrating the semiconductor package of FIG. 1 in the III-III' direction according to another embodiment.

Referring to FIG. 4, a semiconductor package 400 according to the present embodiment may be formed such that at least a portion of a capacitor chip 440 is disposed below semiconductor dies 421 and 425 in the configuration of the semiconductor package 100 of FIGS. 1 to 3. Accordingly, duplicate description of a configuration substantially identical to that of the semiconductor package 100 of FIGS. 1 to 3 will be omitted.

Referring to FIG. 4, the capacitor chip 440 may be disposed below the first semiconductor die 421 or the second semiconductor die 425. For example, the capacitor chip 440 may be disposed in some portion below the first semiconductor die 421. In some cases, the capacitor chip 440 may be disposed in some portion below the second semiconductor die 425. When the first semiconductor die 421 and the second semiconductor die 425 are disposed in close contact, the capacitor chip 440 may be disposed in some portion below each of the first semiconductor die 421 and the second semiconductor die 425.

The capacitor chip 440 may be directly connected to the first semiconductor die 421 or the second semiconductor die 425. Specifically, a first capacitor 441 or a second capacitor 442 of the capacitor chip 440 may be directly connected to the first semiconductor die 421 or the second semiconductor die 425. For example, the first capacitor 441 may include a first connecting member 446 that is directly connected to a chip-to-chip communication part 422 of the first semiconductor die 421 or a first connecting member 446 that is directly connected to a chip-to-chip communication part 426 of the second semiconductor die 425. In addition, the second capacitor 442 may include second connecting members 447 that are directly connected to power voltage parts 423 and 427 of the semiconductor dies 421 and 425 or third connecting members 448 that are directly connected to reference voltage parts 424 and 428 of the semiconductor dies 421 and 425. For example, a second connecting member 447_1 of a first second capacitor 442_1 may be directly connected to the power voltage part 423 of the first semiconductor die 421, and a third connecting member 448_1 may be directly connected to the reference voltage part 424 of the first semiconductor die 421. Accordingly, in the semiconductor package 400, at least one line between the capacitor chip 440 and the semiconductor dies 421 and 425 may be omitted.

The semiconductor package 400 according to one embodiment of the present disclosure includes the capacitor chip 440 disposed below the semiconductor dies 421 and 425 in the package substrate 410 so that integration between components in the package can be improved.

In addition, because the semiconductor package 400 according to one embodiment of the present disclosure includes the capacitor chip 440 directly connected to lower portions of the semiconductor dies 421 and 425, lines between the semiconductor dies 421 and 425 and the capacitor chip 440 may be omitted. Thus, in the semiconductor package 400, by omitting the lines between the semiconductor dies 421 and 425 and the capacitor chip 440, an impedance discontinuity section can be reduced and signal integrity can be improved. Therefore, the semiconductor package 400 may reduce equivalent series inductance (ESL) and equivalent series resistance (ESR) between the components in the package.

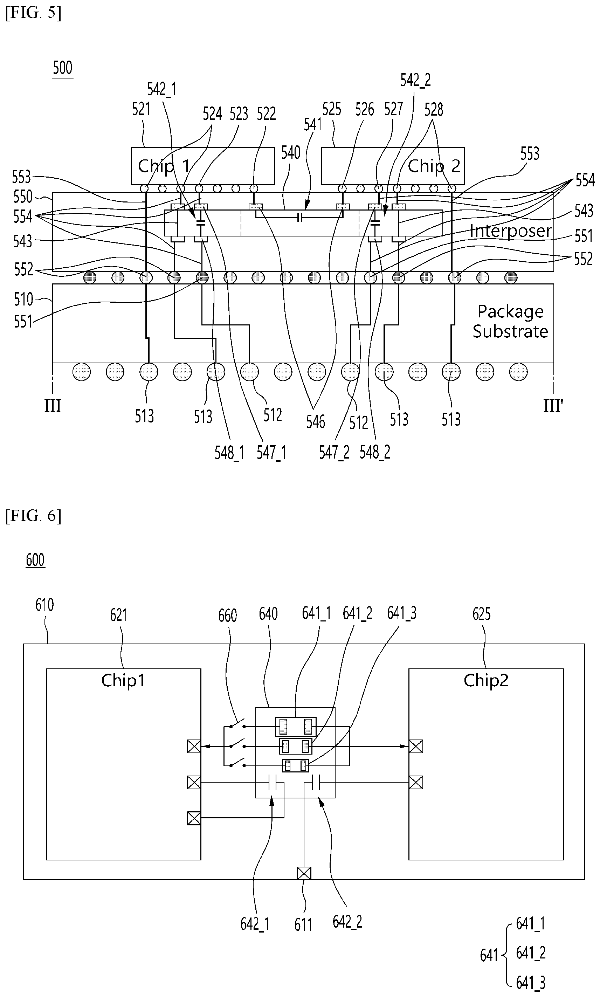

FIG. 5 is a cross-sectional view illustrating the semiconductor package of FIG. 1 in the III-III' direction according to still another embodiment.

Referring to FIG. 5, a semiconductor package 500 according to the present embodiment may further include an interposer 550 in the configuration of the semiconductor package 100 of FIGS. 1 to 3, and a capacitor chip 540 may be disposed in the interposer 550. Accordingly, duplicate description of a configuration substantially identical to that of the semiconductor package 100 of FIGS. 1 to 3 will be omitted.

Referring to FIG. 5, the capacitor chip 540 may include at least one through-silicon via (TSV) 543. The TSV 543 may electrically connect the semiconductor dies 521 and 525, a second through-interposer via (TIV) 554 of the interposer 550, and the fifth connecting member 513 of the package substrate 510. The fifth connecting member 513 may be substantially the same connecting member as the fifth connecting member 113 of FIG. 3.

The semiconductor package 500 according to one embodiment of the present disclosure may form a power supply path between the semiconductor dies 521 and 525 and the package substrate 510 through the TSV 543 by embedding a capacitor chip 540 including the TSV 543 in the interposer 550. Accordingly, the semiconductor package 500 can improve power integrity by shortening the current path length and supplying low-inductance power to the semiconductor dies 521 and 525. In addition, the semiconductor package 500 can improve package integration and space efficiency by integrating the power path and capacitor function into a single chip.

Referring to FIG. 5, the interposer 550 may be disposed below a first semiconductor die 521 and a second semiconductor die 525. Specifically, the interposer 550 may be disposed between the first semiconductor die 521 and the second semiconductor die 525 and a package substrate 510.

The interposer 550 may include a semiconductor material. For example, the interposer 550 may include semiconductor elements such as silicon and germanium or compound semiconductors such as SiC, GaAs, InAs, and InP. Preferably, the interposer 550 may be a silicon interposer.

The interposer 550 may connect the first semiconductor die 521 and the second semiconductor die 525 to the package substrate 510. Specifically, the interposer 550 may connect the first semiconductor die 521 and the second semiconductor die 525 to the package substrate 510 through TIVs 553 and 554, lines, and connecting members 551 and 552.

The interposer 550 may supply power to the first semiconductor die 521 and the second semiconductor die 525 through at least one of a first TIV 553 and a second TIV 554. The first and second TIVs 553 and 554 may electrically connect a fifth connecting member 513 of the package substrate 510, the capacitor chip 540, and the semiconductor dies 521 and 525.

Specifically, the first TIV 553 may directly and electrically connect the semiconductor dies 521 and 525 to the package substrate 510. The second TIV 554 may electrically connect the semiconductor dies 521 and 525 to the second capacitor 542, electrically connect the semiconductor dies 521 and 525 to the TSV 543, electrically connect the second capacitor 542 to the fifth connecting member 513 of the package substrate 510, or electrically connect the TSV 543 to the fifth connecting member 513 of the package substrate 510.

The semiconductor package 500 according to one embodiment of the present disclosure can supply low-inductance power to the semiconductor dies 521 and 525 by electrically connecting the semiconductor dies 521 and 525, the capacitor chip 540, and the power delivery network (PDN) through the TIVs. Accordingly, the semiconductor package 500 can improve power integrity by supplying low-inductance power to the semiconductor dies 521 and 525.

The first and second TIVs 553 and 554 may be formed in various types depending on the material of the interposer 550. For example, a silicon interposer may include through-silicon via(TSV)s formed through deep reactive ion etching (DRIE), and a glass interposer may include through-glass via(TGV)s formed through laser drilling. These vertical through-vias can provide low-inductance electrical connections from the power or ground plane of the package substrate or printed circuit board (PCB) to the decoupling capacitor embedded in the interposer and subsequently to the semiconductor dies, thereby ensuring improved power integrity and high-frequency performance.

The interposer 550 may connect the first semiconductor die 521 and the second semiconductor die 525. For example, the first semiconductor die 521 and the second semiconductor die 525 may be connected to each other through the capacitor chip 540 and bridge lines, which are disposed in the interposer 550. Specifically, the interposer 550 may provide an alternating current (AC) signal path between the first semiconductor die 521 and the second semiconductor die 525 through horizontal interconnects and vias. That is, the coupling signal path between the first semiconductor die 521 and the second semiconductor die 525 may be configured as an electrical path within the interposer 550 and the capacitor chip 540, without a vertical through-via structure such as a TIV, a TSV, or a TGV. This configuration eliminates unnecessary inductive components in the signal path, thereby improving high-speed signal transmission and reducing crosstalk.

Referring to FIG. 5, sixth connecting members 551 or seventh connecting members 552 may be disposed below the interposer 550. Specifically, the sixth connecting members 551 or the seventh connecting members 552 may be disposed between the interposer 550 and the package substrate 510.

The sixth connecting members 551 and the seventh connecting members 552 may include various types of pads or bumps. For example, the sixth connecting members 551 and the seventh connecting members 552 may include Cu pads, W pads, Ni/Au pads, Al pads, solder balls, flip chip bumps, Cu bumps, Au bumps, or polymer bumps. In some cases, the sixth connecting members 551 and the seventh connecting members 552 may each have a structure in which pads and bumps are stacked.

The sixth connecting members 551 and the seventh connecting members 552 may electrically connect the package substrate 510 and the interposer 550. In addition, the sixth connecting members 551 and the seventh connecting members 552 may electrically connect the package substrate 510 and the capacitor chip 540 disposed in the interposer 550. For example, the sixth connecting members 551 may electrically connect the second connecting member 547 or the third connecting member 548 of a second capacitor 542 to the fourth connecting member 512 of the package substrate 510. In addition, the seventh connecting members 552 may electrically connect power voltage parts 523 and 527 or the reference voltage parts 524 and 528 of the semiconductor dies 521 and 525 to a fifth connecting member 513 of the package substrate 510. When the sixth connecting members 551 and the seventh connecting members 552 are electrically connected, the second capacitor 542 may be electrically connected to the power voltage part 523 and 527 or the reference voltage parts 524 and 528 of the semiconductor dies 521 and 525 through the sixth connecting members 551 and the seventh connecting members 552. That is, the sixth connecting members 551 and the seventh connecting members 552 may each be the power voltage part, the reference voltage part, or the ground part of the interposer 550.

FIG. 6 is a top view illustrating a semiconductor package according to another embodiment of the present disclosure.

Referring to FIG. 6, a semiconductor package 600 according to the present embodiment may further include at least one first capacitor 641 in the configuration of the semiconductor package 100 of FIGS. 1 to 3 and may be formed such that a plurality of first capacitors 641 are connected in parallel. Accordingly, duplicate description of a configuration substantially identical to that of the semiconductor package 100 of FIGS. 1 to 3 will be omitted.

Referring to FIG. 6, the plurality of first capacitors 641 may be disposed in one capacitor chip 640. Specifically, the plurality of first capacitors 641 formed on one substrate may be disposed in the capacitor chip 640. For example, a first first capacitor 641_1, a second first capacitor 641_2, or a third first capacitor 641_3 may be disposed in the capacitor chip 640.

Each of the plurality of first capacitors 641 may be electrically connected. Specifically, the plurality of first capacitors 641 may be connected in parallel. For example, one electrode of each of the plurality of first capacitors 641 may be connected to a first semiconductor die 621, and the other electrode of each of the plurality of first capacitors 641 may be connected to a second semiconductor die 625.

The plurality of first capacitors 641 may be connected in parallel in the capacitor chip 640. That is, the plurality of first capacitors 641 may be connected in parallel through lines disposed in the capacitor chip 640. In some cases, at least one electrode of each of the plurality of first capacitors 641 may be electrically connected outside of the capacitor chip 640. Specifically, at least one electrode of each of the plurality of first capacitors 641 may be electrically connected in an electrical path between the plurality of first capacitors 641 and the semiconductor dies 621 and 625 or may be electrically connected in the semiconductor die 621 and 625.

The plurality of first capacitors 641 connected in parallel may be disposed on the electrical path between the first semiconductor die 621 and the second semiconductor die 625. Specifically, the plurality of first capacitors 641 connected in parallel may be coupled to one chip-to-chip communication line between the first semiconductor die 621 and the second semiconductor die 625.

The number of the plurality of first capacitors 641 connected in parallel may be determined according to a frequency of a chip-to-chip communication signal between the first semiconductor die 621 and the second semiconductor die 625. Specifically, the number of the plurality of first capacitors 641 connected in parallel may be determined so that a path having an optimal equivalent capacitance may be formed according to the frequency of the chip-to-chip communication signal between the first semiconductor die 621 and the second semiconductor die 625.

Each of the plurality of first capacitors 641 may be a capacitor substantially identical to the first capacitor 141 of FIGS. 1 to 3. Specifically, each of the plurality of first capacitors 641 may have the same type, the same size, and the same capacitance as the first capacitor 141 of FIGS. 1 to 3.

In some cases, the plurality of first capacitors 641 may have different capacitances. For example, the first first capacitor 641_1 may have the largest capacitance among the plurality of first capacitors 641, the second first capacitor 641_2 may have a smaller capacitance than the first first capacitor 641_1, and the third first capacitor 641_3 may have a smaller capacitance than the second first capacitor 641_2.

Referring to FIG. 6, a plurality of switches 660 may be disposed between the plurality of first capacitors 641 and the semiconductor dies 621 and 625. For example, the switches 660 may be disposed between the first first capacitor 641_1 and the semiconductor dies 621 and 625, disposed between the second first capacitor 641_2 and the semiconductor dies 621 and 625, or disposed between the third first capacitor 641_3 and the semiconductor dies 621 and 625.

The plurality of switches 660 may be disposed at various positions. Specifically, the plurality of switches 660 may be disposed at various positions according to positions at which the electrodes of the plurality of first capacitors 641 are connected to each other. For example, when the plurality of first capacitors 641 are connected through the lines disposed in the capacitor chip 640, the plurality of switches 660 may be disposed in the capacitor chip 640. In addition, when the plurality of first capacitors 641 are connected on the electrical path between the capacitor chip 640 and the semiconductor dies 621 and 625, the plurality of switches 660 may be disposed inside the capacitor chip 640 or disposed on the electrical path between the capacitor chip 640 and the semiconductor dies 621 and 625. When the plurality of first capacitors 641 are electrically connected in the semiconductor dies 621 and 625, the plurality of switches 660 may be disposed inside the capacitor chip 640, disposed on the electrical path between the capacitor chip 640 and the semiconductor dies 621 and 625, or disposed inside the semiconductor dies 621 and 625.

The first semiconductor die 621 or the second semiconductor die 625 may control on/off of each of the plurality of switches 660. Thus, the first semiconductor die 621 or the second semiconductor die 625 may control the switches 660 in real time according to a frequency of a transmission signal, thereby adjusting an equivalent capacitance of the chip-to-chip communication line in real time. Therefore, the first semiconductor die 621 or the second semiconductor die 625 may minimize signal distortion according to a frequency band of the chip-to-chip communication signal and maintain uniform signal quality over a wide bandwidth by adjusting the equivalent capacitance of the chip-to-chip communication line in real time according to the frequency of the transmission signal.

The semiconductor package 600 according to one embodiment of the present disclosure includes the capacitor chip 640 having the plurality of first capacitors 641 connected in parallel so that the equivalent capacitance may be precisely implemented according to the frequency of the chip-to-chip communication signal. In addition, in the semiconductor package 600, even when an error occurs in the capacitance of the capacitor due to a manufacturing error, the target capacitance can be more similarly implemented due to a parallel combination.

In addition, the semiconductor package 600 according to one embodiment of the present disclosure includes the AC coupling capacitor chip 640 in which the plurality of first capacitors 641 connected in parallel and with different capacitances are disposed so that each of the first capacitors 641 may operate with optimal signal transmission characteristics in various frequency bands. For example, the semiconductor package 600 may include a large-capacity first capacitor for low-frequency signal processing, a medium-capacity first capacitor for intermediate frequency processing, and a small-capacity first capacitor for high-frequency processing, thereby enabling use of suitable capacitor paths and maintenance of optimal signal quality in all of the various frequency bands of the chip-to-chip communication.

In addition, in the semiconductor package 600 according to one embodiment of the present disclosure, the plurality of switches 660 are integrated into the capacitor chip 640 so that the complexity of package lines can be reduced and the package assembly process can be simplified.

In addition, the semiconductor package 600 according to one embodiment of the present disclosure includes the switches 660 disposed on the electrical path between the capacitor chip 640 and the semiconductor dies 621 and 625 so that the switches 660 may be disposed on the electrical paths of the plurality of first capacitors 641 without changing the design of the capacitor chip 640 and the semiconductor dies 621 and 625. Therefore, the time and cost required for designing the semiconductor package 600 can be reduced.

In addition, the semiconductor package 600 according to one embodiment of the present disclosure includes the switches 660 disposed in the semiconductor dies 621 and 625 so that the switch control signal path between the semiconductor dies 621 and 625 and the switches 660 can be minimized. Accordingly, in the semiconductor package 600, resistance in the switch control signal path is reduced so that high-speed response and high-speed signal quality of the switches 660 can be secured.

In addition, the semiconductor package 600 according to one embodiment of the present disclosure includes the semiconductor dies 621 and 625 that control the connection of each of the first capacitors 641 connected in parallel using the switches 660, and thus the equivalent capacitance of each chip-to-chip communication line can be precisely adjusted in real time. Therefore, the semiconductor package 600 can minimize signal distortion according to the frequency band of the chip-to-chip communication signal and maintain uniform signal quality over a wide bandwidth.

In addition, the semiconductor package 600 according to one embodiment of the present disclosure includes the coupling capacitor chip 640 in which the plurality of first capacitors 641 with different capacitances are disposed and the semiconductor dies 621 and 625 that control the connection of each of the first capacitors 641 connected in parallel using the switches 660, and thus the equivalent capacitance of each chip-to-chip communication line can be controlled more precisely.

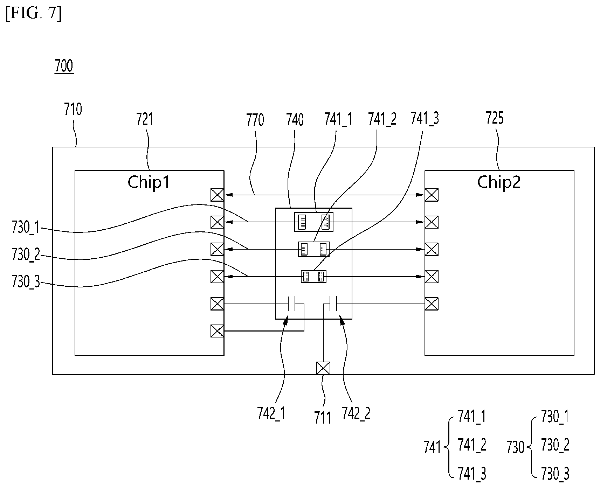

FIG. 7 is a top view illustrating a semiconductor package according to still another embodiment of the present disclosure.

Referring to FIG. 7, a semiconductor package 700 according to the present embodiment may be formed such that a plurality of electrical paths 730 are connected to one capacitor chip 740 in the configuration of the semiconductor package 100 of FIGS. 1 to 3. Accordingly, duplicate description of a configuration substantially identical to that of the semiconductor package 100 of FIGS. 1 to 3 will be omitted.

Referring to FIG. 7, the plurality of electrical paths 730 may be disposed between a first semiconductor die 721 and a second semiconductor die 725. Specifically, at least one chip-to-chip communication line formed of the plurality of electrical paths 730 and at least one chip-to-chip communication line formed of a conductive line 770 may be disposed between the first semiconductor die 721 and the second semiconductor die 725. That is, at least one communication line to which a first capacitor 741 is AC-coupled and at least one communication line to which a conductive line 770 is DC-coupled may be disposed between the first semiconductor die 721 and the second semiconductor die 725.

The plurality of electrical paths 730 may include a first electrical path 730_1, a second electrical path 730_2, and a third electrical path 730_3. Each of the electrical paths 730 may be substantially identical to the electrical path 130 of FIG. 1.

The conductive line 770 may be a bridge line disposed on a package substrate 710. Specifically, the conductive line 770 may be a metal line disposed on the package substrate 710. In some cases, the conductive line 770 may be a metal line disposed in the package substrate 710. According to various embodiments of the present disclosure, the conductive line 770 may be disposed in an interposer disposed between the first and second semiconductor dies 721 and 725 and the package substrate 710.

Referring to FIG. 7, a plurality of first capacitors 741 may be disposed in one capacitor chip 740. Specifically, the plurality of first capacitors 741 formed on one substrate may be disposed in the capacitor chip 740. For example, a first first capacitor 741_1, a second first capacitor 741_2, or a third first capacitor 741_3 may be disposed in the capacitor chip 740.

Each of the plurality of first capacitors 741 may be a capacitor substantially identical to the first capacitor 141 of FIGS. 1 to 3. Specifically, each of the plurality of first capacitors 741 may have the same type, the same size, and the same capacitance as the first capacitor 141 of FIGS. 1 to 3.

In some cases, the plurality of first capacitors 741 may have different capacitances. For example, the first first capacitor 741_1 may have the largest capacitance among the plurality of first capacitors 741, the second first capacitor 741_2 may have a smaller capacitance than the first first capacitor 741_1, and the third first capacitor 741_3 may have a smaller capacitance than the second first capacitor 741_2.

Each of the plurality of first capacitors 741 may be electrically connected to the first semiconductor die 721 and the second semiconductor die 725. Specifically, the plurality of first capacitors 741 may be connected to the first semiconductor die 721 and the second semiconductor die 725 through different electrical paths 730. More specifically, the plurality of first capacitors 741 may be connected to chip-to-chip communication parts of the first semiconductor die 721 and the second semiconductor die 725 through the different electrical paths 730. For example, the first first capacitor 741_1 may be connected to the chip-to-chip communication parts of the first semiconductor die 721 and the second semiconductor die 725 through the first electrical path 730_1, the second first capacitor 741_2 may be connected to the chip-to-chip communication parts of the first semiconductor die 721 and the second semiconductor die 725 through the second electrical path 730_2, and the third first capacitor 741_3 may be connected to the chip-to-chip communication parts of the first semiconductor die 721 and the second semiconductor die 725 through the third electrical path 730_3.

Referring to FIG. 7, the first semiconductor die 721 and the second semiconductor die 725 may selectively use the chip-to-chip communication lines in which the first capacitors 741 with different capacitances are disposed. Specifically, the first semiconductor die 721 and the second semiconductor die 725 may selectively transmit signals to a chip-to-chip communication line in which the first capacitor 741 with an optimal capacitance is disposed according to a type and a frequency of the transmission signal. For example, when the first semiconductor die 721 and the second semiconductor die 725 transmit high-frequency signals, the third first capacitor 741_3 with a relatively small capacitance and the third electrical path 730_3 may be selected to transmit the high-frequency signals.

In some cases, the first semiconductor die 721 and the second semiconductor die 725 may selectively use the communication line in which the first capacitors 741 are disposed and a communication line formed of the conductive line 770. Specifically, the first semiconductor die 721 and the second semiconductor die 725 may select an optimal communication line according to the type and frequency of the transmission signal and transmit a signal through the optimal communication line. The optimal communication line may be determined on the basis of the type and frequency of the transmission signal. For example, the first semiconductor die 721 and the second semiconductor die 725 may transmit a high-frequency signal through a communication line in which the first capacitors 741 are disposed and transmit a low-frequency signal or a DC signal through a communication line formed of the conductive line 770. That is, the first semiconductor die 721 and the second semiconductor die 725 may transmit a relatively high-frequency and high-speed data signal through the communication line in which the first capacitors 741 are disposed, such as a peripheral component interconnect express (PCIe), a universal chiplet interconnect express (UCIe), a universal serial bus (USB) 3.x, a USB 4.0, a double data rate (DDR)4, a DDR5, or a mobile industry processor interface (MIPI) channel state information (CSI)/digital speech interpolation (DSI) and may transmit at least one of a control signal, a state information signal, a clock signal, a serial data signal, an operation setting signal, an interrupt signal, a power, a ground, and a DC signal, which have relatively low-frequencies and low-speeds, through the communication line formed of the conductive line 770, such as an inter-integrated circuit (I2C), a serial peripheral interface (SPI), a general purpose input/output (GPIO) signal, or a universal asynchronous receiver/transmitter (UART). In some cases, the first semiconductor die 721 and the second semiconductor die 725 may transmit an AC signal through a communication line in which the first capacitors 741 are disposed and transmit a DC signal through a communication line formed of the conductive line 770.

The semiconductor package 700 according to one embodiment of the present disclosure includes the capacitor chip 740 in which different electrical paths 730 are connected to the plurality of first capacitors 741, thereby enabling transmission of signals by selecting the various electrical paths 730 according to the characteristics of the signal of the chip-to-chip communication. In particular, when the plurality of first capacitors 741 have different capacitances, the semiconductor package 700 may provide an electrical path optimized for each signal of various frequency bands using only one capacitor chip 740.

In addition, the semiconductor package 700 according to one embodiment of the present disclosure may include an AC communication line in which the first capacitor 741 is coupled and a communication line in which the conductive line 770 is DC coupled, thereby selecting an optimal communication line according to the frequency of a transmission signal and transmitting a signal. Accordingly, the semiconductor package 700 may transmit a high-quality signal without signal distortion or loss over a wide bandwidth.

In addition, the semiconductor package 700 according to one embodiment of the present disclosure may improve the compatibility of semiconductor dies having different frequency characteristics due to having chip-to-chip communication channels of various signal bands. In particular, the semiconductor package 700 includes communication lines in which the first capacitors 741 having different capacitances are disposed so that the semiconductor dies 721 and 725 disposed in the semiconductor package 700 may transmit and receive signals of various signal bands from a low frequency to a high frequency.

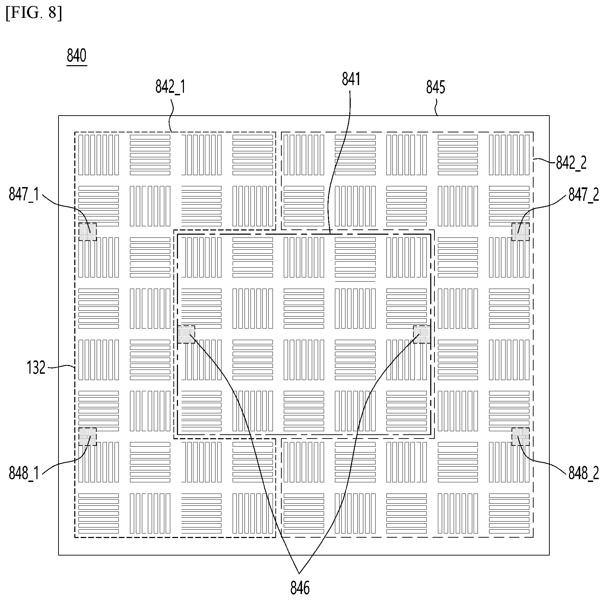

FIG. 8 is a schematic top view illustrating a capacitor chip according to another embodiment of the present disclosure.

Referring to FIG. 8, a capacitor chip 840 according to the present embodiment may be formed such that second capacitors 842 surround a first capacitor 841 in the configuration of the capacitor chip 140 of FIGS. 1 to 3. Accordingly, duplicate description of a configuration substantially identical to that of the capacitor chip 140 of FIGS. 1 to 3 will be omitted.

Referring to FIG. 8, the first capacitor 841 may be disposed in at least one second capacitor 842. Specifically, at least one second capacitor 842 may be disposed to surround the first capacitor 841 in a plane direction of a substrate 845. More specifically, at least one second capacitor 842 may be disposed to be spaced apart from the first capacitor 841 to surround the first capacitor 841. For example, a first second capacitor 842_1 and a second second capacitor 842_2 may be disposed to surround an edge of the first capacitor 841.

The semiconductor package 800 according to one embodiment of the present disclosure includes the capacitor chip 840 in which a decoupling capacitor is disposed to surround a coupling capacitor, thereby minimizing an influence of noise and parasitic components surrounding the coupling capacitor. Accordingly, the semiconductor package 800 may reduce signal jitter and waveform distortion of a chip-to-chip communication signal transmitted through the coupling capacitor.

In addition, the semiconductor package 800 according to one embodiment of the present disclosure includes the capacitor chip 840 in which a decoupling capacitor is disposed to surround a coupling capacitor, thereby minimizing an influence of EMI that may occur in the coupling capacitor according to high-speed chip-to-chip communication. Accordingly, the semiconductor package 800 suppresses EMI emitted to the coupling capacitor, thereby reducing EMI with respect to electronic components in the package and improving signal integrity and electromagnetic suitability of the package system.

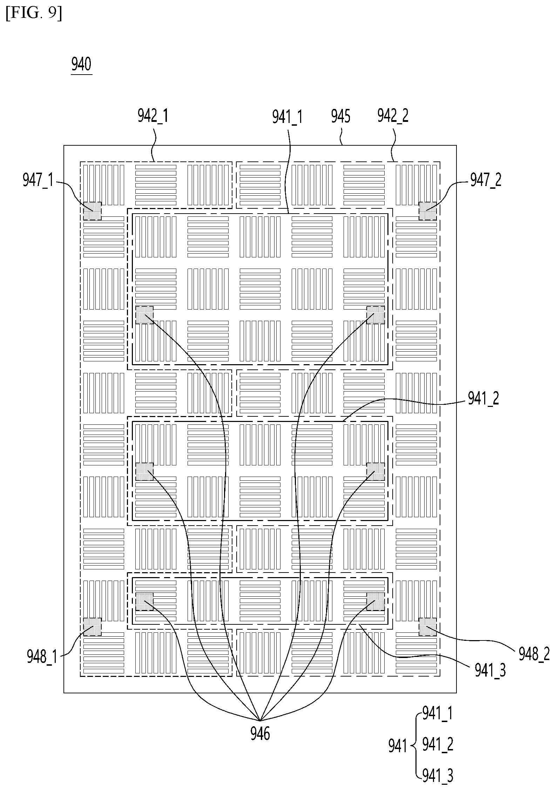

FIG. 9 is a schematic top view illustrating a capacitor chip according to still another embodiment of the present disclosure.

Referring to FIG. 9, a capacitor chip 940 according to the present embodiment may further include at least one first capacitor 941 in the configuration of the capacitor chip 840 of FIG. 8 and may be formed such that each of a plurality of first capacitors 941 is surrounded by second capacitors 942. Accordingly, duplicate description of a configuration substantially identical to that of the capacitor chip 840 of FIG. 8 will be omitted.

Referring to FIG. 9, the plurality of first capacitors 941 may be disposed in one capacitor chip 940. Specifically, the plurality of first capacitors 941 formed on one substrate 945 may be disposed in the capacitor chip 940. For example, a first first capacitor 941_1, a second first capacitor 941_2, or a third first capacitor 941_3 may be disposed in the capacitor chip 940.

The plurality of first capacitors 941 may be substantially the same capacitors as the first capacitors 641 of FIG. 6 or the first capacitors 741 of FIG. 7. That is, the plurality of first capacitors 941 may be connected in parallel and coupled to one chip-to-chip communication line or may each be coupled to a different chip-to-chip communication line. In addition, the plurality of first capacitors 941 may have different capacitances. When the plurality of first capacitors 941 have different capacitances and are coupled to different chip-to-chip communication lines, chip-to-chip communication signals of different frequencies may be transmitted to the plurality of first capacitors 941.

Each of the plurality of first capacitors 941 may be disposed to be surrounded by at least one second capacitor 942 in a plane direction of the substrate 945. Specifically, at least one second capacitor 942 may be disposed between the plurality of first capacitors 941. For example, a first first capacitor 941_1, a second first capacitor 941_2, and a third first capacitor 941_3 may be disposed to be surrounded by a first second capacitor 942_1 and a second second capacitor 942_2.

The semiconductor package 900 according to one embodiment of the present disclosure can suppress mutual interference between coupling capacitors due to having the capacitor chip 940 in which a decoupling capacitor is disposed to surround each of a plurality of coupling capacitors. Chip-to-chip communication lines disposed adjacent to each other may affect each other due to parasitic capacitance or parasitic inductance. In addition, there may be problems that resonance may occur between adjacent chip-to-chip communication lines and coupling capacitors or ripples may occur due to signal reflection. In particular, when signals of different frequencies or high-speed signals are transmitted through adjacent coupling capacitors, noise and EMI induced from the coupling capacitors may cause greater interference at the adjacent coupling capacitors. Conversely, the semiconductor package 900 according to one embodiment of the present disclosure may effectively suppress noise and signal interference that may occur between the coupling capacitors due to having the capacitor chip 940 in which the decoupling capacitor is disposed to surround each of the plurality of coupling capacitors.

According to the present disclosure, a semiconductor package can block common mode noise and improve electromagnetic interference (EMI) performance and signal integrity in chip-to-chip communication due to having a capacitor chip disposed between and coupling a first semiconductor die and a second semiconductor die.

According to the present disclosure, in the semiconductor package, since a plurality of capacitors are integrated into a single capacitor chip, the number of components mounted in the package can be reduced and a packaging process can be simplified.

According to the present disclosure, since the semiconductor package includes the capacitor chip in which a coupling capacitor and a decoupling capacitor are integrated into one substrate, the number of components in a package can be reduced and internal space of the package can be saved. Accordingly, the semiconductor package can implement a highly integrated and high-performance system.

According to the present disclosure, since the semiconductor package includes a capacitor chip directly connected to a semiconductor die in a package substrate or an interposer, an impedance discontinuity section can be reduced and signal integrity can be improved.

According to the present disclosure, since the semiconductor package includes an AC coupling capacitor chip in which a plurality of first capacitors are connected in parallel and have different capacitances, each capacitor can operate as an optimal signal transmission path in various frequency bands.

According to the present disclosure, since the semiconductor package includes a semiconductor die that controls a connection of each of the first capacitors connected in parallel using a switch, an equivalent capacitance of each chip-to-chip communication line can be precisely adjusted in real time.

According to the present disclosure, since the semiconductor package includes a capacitor chip in which different electrical paths are connected to the plurality of first capacitors, an electrical path optimized for each signal of various frequency bands can be provided using only one capacitor chip.

According to the present disclosure, since the semiconductor package includes a capacitor chip in which a decoupling capacitor is disposed to surround a coupling capacitor, influences of noise and parasitic components surrounding the coupling capacitor can be minimized and the integrity of a chip-to-chip communication signal transmitted through the coupling capacitor can be secured.

The effects obtained by the present disclosure are not limited to the above-mentioned effects and other effects which are not mentioned can be clearly understood by those skilled in the art to which the present invention pertains from the above description.

Although embodiments of the present disclosure have been described in more detail with reference to the accompanying drawings, the present disclosure is not necessarily limited to these embodiments and may be variously modified without departing from the technical spirit of the present disclosure. The embodiments disclosed herein, therefore, are not to be taken in a sense for limiting the technical concept of the present disclosure but for explanation thereof, and the range of the technical concept of the present disclosure is not limited to these embodiments. Therefore, it should be understood that the above-described embodiments are not restrictive but illustrative in all aspects. The scope of the present disclosure should be construed from the appended claims, along with the full range of equivalents to which such claims are entitled.

## Claims

1. A semiconductor package comprising:
a package substrate;
a first semiconductor die disposed on the package substrate;
a second semiconductor die disposed to be spaced apart from the first semiconductor die on the package substrate; and
a capacitor chip disposed on at least one electrical path between the first semiconductor die and the second semiconductor die on the package substrate,
wherein the capacitor chip includes:
a substrate including a plurality of trenches;
at least one first trench capacitor disposed in one area of the substrate; and
at least one second trench capacitor disposed to be spaced apart from the at least one first trench capacitor in another area of the substrate,
the at least one first trench capacitor couples the first semiconductor die and the second semiconductor die, and
the at least one second trench capacitor is a decoupling capacitor connected to the first semiconductor die or the second semiconductor die.

2. The semiconductor package of claim 1, wherein the first semiconductor die and the second semiconductor die are heterogeneous semiconductor dies having different driving voltages.

3. The semiconductor package of claim 1 or 2, wherein, when the at least one second trench capacitor is provided as a plurality of second trench capacitors, the first semiconductor die and the second semiconductor die are connected to different second trench capacitors.

4. The semiconductor package of any one of claims 1 to 3, wherein the capacitor chip is disposed in the package substrate.

5. The semiconductor package of any one of claims 1 to 4, wherein the capacitor chip is:
disposed below the first semiconductor die or the second semiconductor die; and
directly connected to a lower surface of the first semiconductor die or the second semiconductor die.

6. The semiconductor package of any one of claims 1 to 5, further comprising an interposer disposed between the first and second semiconductor dies and the package substrate,
wherein the capacitor chip is disposed in the interposer.

7. The semiconductor package of any one of claims 1 to 6, wherein:
the at least one first trench capacitor includes a plurality of first trench capacitors; and
the plurality of first trench capacitors are connected in parallel.

8. The semiconductor package of claim 7, further comprising a plurality of switches disposed between each of the plurality of first trench capacitors and the first semiconductor die or disposed between each of the plurality of first trench capacitors and the second semiconductor die,
wherein the plurality of first trench capacitors have different capacitances.

9. The semiconductor package of any one of claims 1 to 6, wherein, when the at least one first trench capacitor includes a plurality of first trench capacitors and the at least one electrical path is provided as a plurality of electrical paths, the electrical paths are connected to the capacitor chip, and each of the plurality of electrical paths connects the first semiconductor die and the second semiconductor die through each of the plurality of first trench capacitors.

10. The semiconductor package of claim 9, wherein the plurality of first trench capacitors have different capacitances.

11. The semiconductor package of claim 9 or 10, wherein:
the plurality of electrical paths include electrical paths formed of conductive lines; and
the conductive lines DC-couple the first semiconductor die and the second semiconductor die.

12. The semiconductor package of any one of claims 6 to 11, wherein the capacitor chip is embedded in the interposer, and
the trench capacitors in the capacitor chip are electrically connected to the semiconductor dies through internal routing layers of the interposer.

13. The semiconductor package of any one of claims 6 to 12, wherein the interposer includes at least one through-interposer via (TIV), and
wherein the second trench capacitor is electrically connected to one of the semiconductor dies through the at least one TIV.

14. The semiconductor package of claim 13, wherein the capacitor chip further includes a through-silicon via (TSV), and
wherein the TSV electrically connects the package substrate and the first semiconductor die or the second semiconductor die through the at least one TIV.
